Europäisches Patentamt

European Patent Office

Office européen des brevets

(11) Publication number: **0 313 095**
**A2**

## EUROPEAN PATENT APPLICATION

(21) Application number: 88117613.5

(22) Date of filing: 21.10.88

(51) Int. Cl.⁴: **C07F 7/08** , **C23C 18/12**

(30) Priority: 23.10.87 JP 268949/87

(43) Date of publication of application:
26.04.89 Bulletin 89/17

(84) Designated Contracting States:
**DE GB**

(71) Applicant: Hitachi Chemical Co., Ltd.
1-1, Nishi-shinjuku 2-chome Shinjuku-ku
Tokyo 160(JP)

(72) Inventor: Uchimura, Shun-ichiro
16-5-203 Sukegawacho 5-chome
Hitachi-shi Ibaraki-ken(JP)
Inventor: Sato, Hidetaka
16-14-1 Takasuzucho 1-chome
Hitachi-shi Ibaraki-ken(JP)

(74) Representative: Strehl, Schübel-Hopf,
Groening, Schulz
Maximilianstrasse 54 Postfach 22 14 55
D-8000 München 22(DE)

(54) Method for preparing hydroxysilanes and/or their oligomers.

(57) A method for preparing hydroxysilanes and/or their oligomers which comprises reacting an alkoxysilane with water in a solvent by using a solid acid catalyst. The thus-produced alkoxysilanes and/or their oligomers can be suitably used for the preparation of $SiO_2$-film-forming application-liquids.

## METHOD FOR PREPARING HYDROXYSILANES AND/OR THEIR OLIGOMERS

### BACKGROUND OF THE INVENTION

(a) Field of the Invention

The present invention relates to a method of preparing hydroxysilanes and/or their oligomers that are useful as silicon-oxide-film-forming application-liquids for preparing films of silicon oxide, which will be described below as $SiO_2$-films, on the surface of substrates, including especially, silicon, glass, ceramics, metals, etc..

(b) Description of the Related Art

$SiO_2$-films have been widely used as alkaline-ion-elution-preventing coatings for preventing the elution of alkaline ions from glass substrates used in liquid crystal display devices, orientation-controlling films for liquid crystal devices, passivation films of SC, LSI, etc., and the like.

They are also widely used as diffusion sources that can be prepared by doping boron(B), phosphorous(P), etc., protective coatings for reinforcing the surface of glass bottles, and the like.

Vapor growth methods and application methods are generally known as the methods for preparing such $SiO_2$-films.

The former methods, however, have disadvantages in that a special apparatus is required for the preparation, they are unsuitable for mass production of the $SiO_2$-films, and so on. On the other hand, the latter methods are adaptable to the mass production by using a simple apparatus.

Typical of some of the latter methods disclosed are: (1) the method characterized by using the products obtained by the reaction of a halogenated silane, a carboxylic acid, and an alcohol as the film-forming compositions (as disclosed in Japanese Patent Application Publication Nos. 52-16488 and 52-20825), (2) the method characterized by using the products obtained by the reaction of an alkoxysilane, an organic carboxylic acid, and an, alcohol in the presence of an inorganic acid as a catalyst (as disclosed in Japanese Patent Application Publication No. 56-34234), (3) the method characterized by using the products obtained by reacting a mixture of an alkoxysilane, a lower carboxylic acid, and an alcohol, in the presence of an organic carboxylic acid or organic sulfonic acid as a catalyst (as disclosed in Japanese Patent Application Publication No. 57-39659), and so on.

However, the method (1) has a disadvantage in that if the application -liquids are applied on the substrates and then heat-treated to form $SiO_2$-films, the materials, including substrates, apparatus, etc., used are corroded by the action of the halide ions remaining in application-liquids, the halide ions being from hydrogen halides and/or carboxylic acid halides that are formed by the reaction as by-products.

The method (2) can remove such a disadvantage of the method (1) if halogen-free inorganic acids are used. However, it has another disadvantage in that the use of the inorganic acids results in the introduction of dopants to application-liquids, and, as a result, the products obtained in the method (2) have limitations on their uses.

The method (3) can offset both the disadvantages of the methods (1) and (2). However, the following disadvantages arise :

Since the use of the equivalent mixture of alkoxysilanes and carboxylic acids is required, esters formed from the carboxylic acids remain in the application-liquids, causing limitation on the solvents to be used and poor storage stability of the resulting application-liquids.

### SUMMARY OF THE INVENTION

An object of the present invention is to remove the disadvantages of the prior arts described above, and to provide a method for preparing hydroxysilanes and/or their oligomers that give $SiO_2$-film-forming application-liquids that are free from halide ions as well as dopants and have a good storage-stability, and can remove the limitations on the solvents to be used.

Another object of the present invention is to provide a method for preparing hydroxysilanes and/or their oligomers which permits easy separation of the catalysts used in the reaction.

The present invention provides a method for preparing hydroxysilanes and/or their oligomers which comprises reacting alkoxysilanes with water in the presence of a solvent by using a solid acid catalyst.

### DESCRIPTION OF THE PREFERRED EMBODIMENTS

Alkoxysilanes do not react with water simply by mixing them in a solvent with stirring and/or heating. In the present invention, the reaction exothermically proceeds by bringing the mixture in contact with a solid acid catalyst, giving hydroxysilanes and/or their oligomers as the products.

The reaction can be readily stopped by simply separating the resulting reaction solution from the solid acid catalyst used. By this simple technique, a stable and catalyst-free solution can be obtained.

Some non-limiting illustrative examples of the alkoxysilanes that can be used in the present invention include tetraalkoxysilanes represented by the following general formula:

$Si(OR^1)_4$

wherein $R^1$ is hydrogen or a monovalent hydrocarbon radical,

such as tetramethoxysilane, tetraethoxysilane, tetraisopropoxysilane, tetrabutoxysilane, tetrapropoxysilane, tetrakis(2-ethylbutoxy)silane, tetrakis(2-methoxyethoxy)silane, tetraphenoxysilane, etc.; oligomers of these tetraalkoxysilanes including, for example, Kalcoat 40 (trade name) made by Japan Kalcoat Co. Ltd.; the alkoxysilanes represented by the following general formula:

$R_nSi(OR^2)_{4-n}$

wherein each R and $R^2$ is independently hydrogen or a monovalent hydrocarbon radical, and n is an integer of 1 - 3,

including alkyl trialkoxysilanes, dialkyl dialkoxysilanes, and trialkyl alkoxysilanes; and oligomers of the alkyl trialkoxysilanes and/or dialkyl dialkoxysilanes; and the like. Among the alkoxysilanes described above, preferred are those wherein $R^1$ and $R^2$ in the above formulas are methyl radical or ethyl radical.

These alkoxysilanes can be used individually or as a combination of two or more of them. It is particularly preferred to use tetramethoxysilane or tetraethoxysilane.

Some non-limiting illustrative examples of the solvents that can be used in the present invention include alcohols such as methanol, ethanol, propyl alcohol, isopropyl alcohol, butyl alcohol, etc.; Cellosolves such as methyl cellosolve, ethyl cellosolve, butyl cellosolve, etc.; carbitols such as methyl carbitol, ethyl carbitol, butyl carbitol, etc.; polyalcohols such as ethylene glycol, propylene glycol, diethylene glycol, glycerin, etc.; esters such as methyl acetate, ethyl acetate, butyl acetate, etc.; ketones such as acetone, methyl ethyl ketone, acetyl acetone, etc.; amides such as N-methyl-2-pyrrolidone, dimethylacetamide, dimethylformamide, etc.; dimethyl sulfoxide; and the like.

It is preferred that the concentration of the alkoxysilanes in the starting reaction mixtures is in the range of 1 - 20 % by weight.

The water to be used in the present invention is preferably distilled water and/or ion-exchanged water. It is preferred that the amount of water used is almost equivalent to that of the alkoxy groups in the alkoxysilanes used.

Some non-limiting illustrative examples of the solid acid catalysts that can be used in the present invention include metal oxides such as $Al_2O_3$, $ThO_2$, $ZrO_2$, $Fe_2O_3$, etc.; mixed metal oxides such as $Al_2O_3$-$SiO_2$, $TiO_2$-$SiO_2$, $Al_2O_3$-$B_2O_3$, $Bi_2O_3$-$MoO_3$, etc.; clay minerals such as X-zeolite, Y-zeolite, mordenite, montmorillonite, etc.; those obtained by adding or adsorbing sulfuric acid, phosphoric acid, boric acid, heteropoly acid or the like to $Al_2O_3$-$SiO_2$; cation-exchange resins consisting of chemically modified gels, including sulfonated gels; fluorinated sulfonic acid type resins, including Nafion-H (trade name) made by E. I. du Pont de Nemours and Company; and the like.

Typical of some of the procedures that may be used in the present invention include procedures wherein the reaction is conducted at room temperature or under heating by stirring the mixture of the alkoxysilane, solvent, and water in the presence of the solid acid catalyst until the intended conversion is attained, and then the solid acid catalyst used is separated from the resulting reaction mixture by filtration, centrifugation, etc.; procedures wherein the reaction is continuously conducted at room temperature or under heating by introducing the mixture of the alkoxysilane, solvent, and water to a column in which the solid acid catalyst has been packed; and the like.

In any procedure, the degree of the hydrolysis of the alkoxysilane used can be controlled by adjusting the amount of time the solid acid catalyst is contacted the mixture of the alkoxysilane, solvent, and water, reaction temperature, and the acidity of the solid acid catalyst.

The composition obtained by reacting the alkoxysilane with water in the solvent in the presence of the solid acid catalyst, i.e. all of the resulting reaction mixture exclusive of the solid acid catalyst used, may be used as it is as $SiO_2$-film-forming application-liquid. Also, the composition may be used as the $SiO_2$-film-forming application-liquid by adding the same solvent used or another solvent to the compositions, or by replacing the solvent used in the reaction with another solvent.

Moreover, surface-active agents can be added to the $SiO_2$-film-forming application-liquids in order to improve the wettability of the application-liquids toward substrates. Coupling agents such as silane-coupling agents can also be added to the application-liquids to improve the adhesive property of them toward substrates.

Furthermore, in the case that the application-liquids are used as diffusion sources for semiconductors, metal compounds such as compounds of P, B, As, Ga, Sb, Ti, In, Al, etc. can be added to them.

The preparation of SiO$_2$-film by using the SiO$_2$-film-forming application-liquids of the present invention can be conducted by applying the application-liquids to substrates, preferably at room temperature, by using known techniques such as spinner methods, dipping-lifting methods, brushing methods, flexographic printing methods, roll-coater methods, offset printing methods, etc., followed by heating preferably at temperatures of 200 - 600 °C.

The present invention is now described in more detail with reference to the following examples. These examples, however, are intended to illustrate the invention and are not to be construed to limit the scope of the invention.

EXAMPLE 1

To a 200-ml flask equipped with a thermometer, cooling tube, and stirrer were charged 23.0 g of tetraethoxysilane, 70 g of ethanol, and 7.95 g of ion-exchanged water, and the resulting mixture was stirred. To the resulting mixture was added 10 g of Y-zeolite, and the reaction was conducted at temperatures of 30 - 35 °C for 3 hours with stirring. It was confirmed by analyzing the samples withdrawn from the reaction mixture by gas chromatography that the amount of tetraethoxysilane remaining in the reaction mixture after one hour of the reaction was almost zero.

After 3 hours of the reaction, the Y-zeolite was filtered by using a glass filter, and an application-liquid containing hydroxysilanes and their oligomers was obtained.

The heating residue of the application-liquid were 9.0 % by weight at 150 °C and 7.9 % by weight at 500 °C.

REFERENTIAL EXAMPLE 1

A SiO$_2$-film having a thickness of about 2000 Å was obtained by applying the application liquid described above to a silicon wafer at room temperature by using a spinner at 3000 r.p.m., followed by heating at 500 °C.

The application-Liquid was very stable and no gelation occurred even when it was allowed to stand for not less than 3 months at 40 °C in a thermostat.

The concentration of halide ions in the application-liquid was determined by ion chromatography to be not more than 1 ppm.

EXAMPLE 2

To the same reaction apparatus that was used in Example 1 were charged 17.0 g of tetramethoxysilane, 50 g of N,N-dimethylformamide, and 10 g of methyl cellosolve, and to the resulting mixture was added 7.88 g of water. After the resulting mixture was stirred, the reaction was continuously conducted by introducing the mixture in a rate of 10 g/min. to a glass column of 10 mm$\phi$ x 20 cm in which a fluorinated sulfonic acid type resin has been packed.

The resulting reaction mixture was analyzed by gas chromatography in a similar manner to that of Example 1 ; and, as a result, no tetramethoxysilane was detected.

The heating residue of the application-liquid was 9.2 % by weight at 150 °C and 8.0 % by weight at 500 °C.

REFERENTIAL EXAMPLE 2

A SiO$_2$-film having a thickness of 3000 Å was obtained by applying the application-liquid described above to a glass substrate by a dipping-lifting method, followed by heating at 500 °C.

This application-liquid was very stable, and no gelation occurred even when it was allowed to stand for not less than 3 months at 40 °C in a thermostat.

The concentration of halide ions in the application-liquid was not more than 1 ppm.

**Claims**

1. A method for preparing hydoxysilanes and/or their oligomers which comprises reacting an alkoxysilane or an oligomer thereof with water in a solvent in the presence of a solid acid catalyst.

2. The method of claim 1 wherein the alkoxysilane is represented by the following general formulas:
$$Si(OR^1)_4$$
wherein R$^1$ is hydrogen or a monovalent hydrocarbon radical,
or
$$R_nSi(OR^2)_{4-n}$$
wherein each R and R$^2$ is independently hydrogen or a monovalent hydrocarbon radical, and n is an integer of 1 - 3.

3. The method of claim 2 wherein each R$^1$ and R$^2$ is methyl radical or ethyl radical.

4. The method of any of claims 1 to 3, wherein the solid acid catalyst is Y-zeolite.

5. The method of any of claims 1 to 3, wherein the solid acid catalyst is fluorinated sulfonic acid type resin.

6. A SiO$_2$-film-forming application-liquid comprising hydroxysilanes and/or their oligomers prepared by the method according to any of claims 1 to 5.

7. A diffusion source for semiconductors comprising hydroxysilanes and/or their oligomers prepared by the method according to any of claims 1 to 5.

8. A method for preparing SiO$_2$-films which comprises:

applying a SiO$_2$-film-forming application-liquid comprising hydroxysilanes and/or their oligomers, and

heating the applied SiO$_2$-film-forming application-liquid, wherein the hydroxysilanes and/or their oligomers are prepared by the method according to any of claims 1 to 5.

9. A method for preparing doped layers which comprises applying a diffusion source for semiconductors on a silicon wafer, the diffusion source for semiconductors comprising hydroxysilanes and/or their oligomers, and

heating the applied diffusion source for semiconductors, wherein the hydroxysilanes and/or their oligomers are prepared by the method according to any of claims 1 to 5.